(19) Europäisches Patentamt
European Patent Office
Office européen des brevets

(11) **EP 2 289 292 B1**

(12) **FASCICULE DE BREVET EUROPEEN**

(45) Date de publication et mention
de la délivrance du brevet:
**09.08.2017 Bulletin 2017/32**

(51) Int Cl.:
***H05K 7/20*** *(2006.01)*

(21) Numéro de dépôt: **09772657.4**

(86) Numéro de dépôt international:
**PCT/FR2009/000694**

(22) Date de dépôt: **10.06.2009**

(87) Numéro de publication internationale:
**WO 2010/000974 (07.01.2010 Gazette 2010/01)**

(54) **SYSTÈME DE DISSIPATION DE CHALEUR**

WÄRMEABSCHWÄCHUNGSSYSTEM

HEAT DISSIPATION SYSTEM

(84) Etats contractants désignés:
**AT BE BG CH CY CZ DE DK EE ES FI FR GB GR
HR HU IE IS IT LI LT LU LV MC MK MT NL NO PL
PT RO SE SI SK TR**

(30) Priorité: **10.06.2008 FR 0853838**

(43) Date de publication de la demande:
**02.03.2011 Bulletin 2011/09**

(73) Titulaire: **AIRBUS OPERATIONS**
**31060 Toulouse (FR)**

(72) Inventeurs:
• **COLONGO, Emile**
**31310 Montesquieu Volvestre (FR)**
• **REBEYROTTE, Vincent**
**31770 Colomiers (FR)**

(74) Mandataire: **Santarelli**
**49, avenue des Champs-Elysées**
**75008 Paris (FR)**

(56) Documents cités:
**EP-A- 0 144 071    FR-A- 1 266 244**

**Description**

La présente invention concerne un système de dissipation de chaleur.

Elle vise tout particulièrement un système de dissipation de la chaleur produite par un système électronique, notamment par un équipement électronique dans un aéronef.

Les systèmes électroniques s'échauffent lors de leur fonctionnement. La fiabilité et la qualité des systèmes électroniques dépendent fortement de la température à laquelle ils sont soumis. En effet, si les systèmes électroniques sont soumis à des températures trop élevées, ils peuvent montrer des défaillances.

Ainsi, la chaleur produite par le fonctionnement d'un système électronique doit être dissipée et dirigée vers une source froide. Afin de faciliter cela, la résistance thermique entre le système et la source froide doit être réduite au minimum.

Néanmoins, si la température de la source froide varie fortement, la température du système électronique subit les changements de température.

La fiabilité des systèmes électroniques qui sont soumis à des grandes variations de température est fortement réduite et leur vieillissement est accéléré.

Par ailleurs, dans un aéronef, il est intéressant de positionner certains équipements électroniques en dehors des zones protégées de l'aéronef. Les conditions thermiques de ces zones non protégées sont proches des conditions extérieures de l'aéronef.

Par exemple, des zones non protégés sont le cône arrière ou l'intérieur de la voilure de l'aéronef.

Ainsi, les équipements électroniques sont soumis aux contraintes environnementales, et notamment à des conditions thermiques extrêmes.

Par conséquent, la fiabilité de tels équipements électroniques est réduite et leur vieillissement accéléré.

On connaît ainsi dans le document EP 1 615 488 un circuit imprimé logé dans un boitier et en contact avec une couche d'interface formant un drain thermique.

Le document EP 0 144 071 décrit un dispositif à l'état solide à refroidir. Ce dispositif à l'état solide est disposé dans une enceinte qui contient un liquide de refroidissement.

Le document FR 1 266 244 décrit un système de dissipation de la chaleur produite par un élément semi-conducteur, l'élément semi-conducteur étant enfermé dans un capot. Un couvercle à double paroi est fixé sur le capot, la double paroi contenant un liquide.

Toutefois, des tels systèmes de dissipation de chaleur sont limités à l'utilisation d'une source froide en contact avec le système électronique.

La présente invention a pour but de proposer un système de dissipation de la chaleur permettant en même temps de réduire l'influence des variations thermiques de la source froide sur l'équipement électronique dans un aéronef.

A cet effet, la présente invention concerne selon un premier aspect un système de dissipation de la chaleur produite par un système électronique, notamment par un équipement électronique dans un aéronef, le système de dissipation comportant un boîtier qui comporte un capot externe recouvrant le système électronique et adapté à être en contact avec une première source froide, et une seconde source froide située à l'intérieur du capot externe.

Selon l'invention, le boîtier comporte un capot interne situé à l'intérieur du capot externe et recouvrant le système électronique, la seconde source froide étant située entre les capots interne et externe, de sorte que l'influence des variations de température de la première source froide sur le système électronique est atténuée.

Ainsi, le boîtier et la seconde source froide (qui sont disposés entre le système électronique et la première source froide) atténuent l'influence des variations de température de la première source froide sur le système électronique. Par conséquent, le système électronique subit faiblement les variations de température de la première source froide, tout en permettant la dissipation de la chaleur produite par le système électronique.

Par ailleurs, le capot interne protège le système électronique du contact avec la seconde source froide.

Selon une caractéristique préférée, le capot interne et le capot externe forment une cavité contenant la seconde source froide.

Ainsi, le système électronique est entouré par la seconde source froide, et par conséquent isolé de la première source froide. Ainsi, l'influence des changements de température de la première source froide sur le système électronique est minimisée.

Par conséquent, si par exemple la première source froide est l'air ambiant, la chaleur produite par l'équipement électronique dans un aéronef est dirigée vers l'air ambiant, et en même temps le système électronique est isolé de l'air ambiant et moins exposé aux contraintes de l'environnement.

En outre, l'équipement électronique subit faiblement les changements de température de l'environnement.

En effet, il est nécessaire d'extraire la chaleur dissipée par l'équipement électronique et en même temps, de protéger l'équipement électronique de l'influence des conditions thermiques extrêmes.

Selon un mode de réalisation, la seconde source froide a une valeur de capacité thermique supérieure à la valeur de capacité thermique de la première source froide.

Ainsi, la seconde source froide absorbe les variations de température de la première source froide et le système électronique subit faiblement les variations de température de la première source froide, tout en permettant la dissipation de la chaleur produite par le système électronique.

Avantageusement, la seconde source froide comporte de l'eau.

Grâce à l'importante capacité thermique de l'eau, les changements de température de l'air ambiant sont tempérés par l'eau.

En pratique, le boîtier comporte six faces, une première face étant fixée à un support et les cinq autres faces étant adaptées à être en contact avec la première source froide.

Ainsi, la surface du boîtier à travers laquelle la chaleur produite par le système électronique est transmise vers la première source froide, est maximisée.

L'invention vise, selon un second aspect, un aéronef comportant un système de dissipation selon l'invention.

Par conséquent, lorsque le système de dissipation selon l'invention est employé afin de dissiper la chaleur produite par un équipement électronique situé dans une zone non pressurisée d'un aéronef, la fiabilité et la durée de vie de l'équipement électronique sont augmentées.

Cet aéronef présente des caractéristiques et avantages analogues à ceux décrits précédemment en relation avec le système de dissipation.

D'autres particularités et avantages de l'invention apparaîtront encore dans la description ci-après.

Aux dessins annexés, donnés à titre d'exemples non limitatifs :

- la figure 1 est un schéma illustrant une coupe longitudinale d'un système de dissipation selon un mode de réalisation de l'invention ;
- la figure 2a représente l'évolution de la température d'une première source froide dans le temps ;
- la figure 2b représente l'évolution de la température d'une seconde source froide dans le temps ; et
- la figure 2c représente l'évolution de la température d'un système électronique dans le temps.

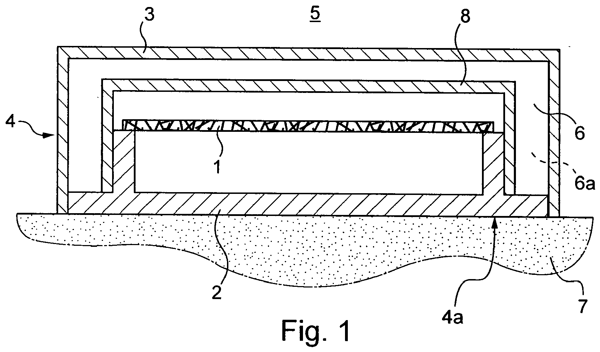

On va décrire tout d'abord en référence à la figure 1, un système de dissipation conforme à un mode de réalisation de l'invention.

Une carte électronique 1 comportant un système électronique, est fixée sur un support ou châssis 2.

Un capot 3 est également fixé au châssis 2, formant avec celui-ci un boîtier 4. Ainsi, ce boîtier 4 enferme et protège de l'extérieur la carte électronique 1.

Ainsi, les dimensions du boîtier 4 sont fonction des dimensions de la carte électronique 1.

Dans cet exemple, le boîtier 4 présente une forme de parallélépipède.

A titre d'exemple nullement limitatif, la longueur et la largeur du boîtier peuvent être comprises dans une plage de 200 à 500 mm et la hauteur peut être comprise dans une plage de 20 à 300 mm.

Le boîtier peut être par exemple en aluminium ou en matériaux composites.

Bien entendu, les dimensions et matériaux dans lesquels sont construits les boîtiers peuvent être différents.

Ici, l'extérieur du boîtier 4 est en contact avec l'air ambiant 5, qui représente une première source froide 5.

En effet, la chaleur produite par la carte électronique 1 est dirigée vers la source froide 5, c'est-à-dire vers l'air ambiant 5, à travers le boîtier 4.

Le boîtier 4 comporte un capot interne 8 situé à l'intérieur du capot externe 3 et recouvrant le système électronique 1 (ici, carte électronique 1).

Ainsi, le capot interne 8 est disposé entre la carte électronique 1 et le capot externe 3.

Les capots 3, 8 forment entre eux une cavité 6. Cette cavité 6 comporte un matériau qui constitue une seconde source froide 6a.

La capacité thermique de la seconde source froide 6a est de valeur supérieure à celle de la première source froide 5, c'est-à-dire que la seconde source froide nécessite un apport d'énergie thermique supérieure à la première source froide pour subir une augmentation de température.

Ici, le matériau constituant la seconde source froide 6a est principalement de l'eau, comme par exemple le propylène glycol-water.

Dans ce mode de réalisation, pour un équipement ou système électronique 1 occupant un volume de 800ml (volume équivalent à une élévation du niveau d'eau générée par l'immersion de l'équipement ou système électronique 1 dans une cuve remplie d'eau), le volume d'eau à l'intérieur de la cavité 6 est de 330 ml.

Le capot interne 8 protège la carte électronique 1 du contact avec le matériau constituant la seconde source froide 6a, ici l'eau.

Bien entendu, le volume peut présenter des valeurs différentes.

Par ailleurs, d'autres matériaux de forte valeur de capacité thermique peuvent être employés, comme par exemple, le Galden® (commercialisé par SOLVAY) ou le methoxy-nanofluorobutane.

La capacité thermique (Cth) des matériaux est calculée au moyen de la formule suivante connu de l'homme

du métier :

$$Cth = \rho \times Cp \times V$$

dans laquelle p est la densité du matériau, Cp est la capacité thermique massique du matériau et V le volume de matériau employé.

Ainsi, par exemple, la capacité thermique volumique de l'air, de l'eau et de l'aluminium présentent les valeurs suivantes :

$$Cth_{air} = 1,2 \ kg/m^3 \times 1 \ 407 \ J/(kg.K) \times V = 1 \ 688 \ J/m^3 \times V$$

$$Cth_{eau} = 1 \ 000 \ kg/m^3 \times 4 \ 180 \ J/(kg.K) \times V = 4 \ 180 \ 000 \ J/m^3 \times V$$

$$Cth_{al} = 2 \ 800 kg/m^3 \times 910 \ J/(kg.K) \times V = 2 \ 548 \ 000 \ J/m^3 \times V$$

Le boîtier 4 est fixé par une de ces faces 4a à un support 7, les cinq autres faces restantes étant en contact avec la première source froide 5.

Ainsi, les cinq faces en contact avec la première source froide 5 (ici, l'air ambiant) permettent d'échanger la chaleur dissipée par la carte électronique 1 avec l'air ambiant 5 par convection naturelle.

On notera que la taille et le matériau dans lequel le boîtier 4 est construit présente un impact sur la capacité d'échange thermique entre la seconde source froide 6a et le boîtier 4 et entre le boîtier 4 et la première source froide 5.

Dans d'autres modes de réalisation, le boîtier 4 peut être adapté à augmenter (ou à diminuer) sa capacité d'échange thermique avec l'air ambiant 5, par exemple en augmentant (ou en diminuant) la surface du boîtier 4 en contact avec l'air ambiant 5 ou en modifiant le matériau dans lequel est constitué le boiter 4.

Une façon d'augmenter la surface du boîtier 4 en contact avec l'air ambiant 5, sans pour autant augmenter le volume du boîtier 4, est de rajouter des ailettes.

Bien entendu, d'autres moyens d'échange de chaleur peuvent être employés, par exemple la convection forcée.

En effet, il existe des échanges de température entre la carte électronique 1 et l'eau 6a, et entre l'eau 6a et l'air ambiant 5 (à travers le boîtier) au lieu des échanges entre la carte électronique 1 et l'air ambiant 5 directement.

Grâce à la forte valeur de la capacité thermique de la seconde source froide 6a, la carte électronique 1 subit plus faiblement les variations de température de l'air ambiant 5. En effet, les changements de températures de l'air ambiant 5 sont atténués par l'eau 6a.

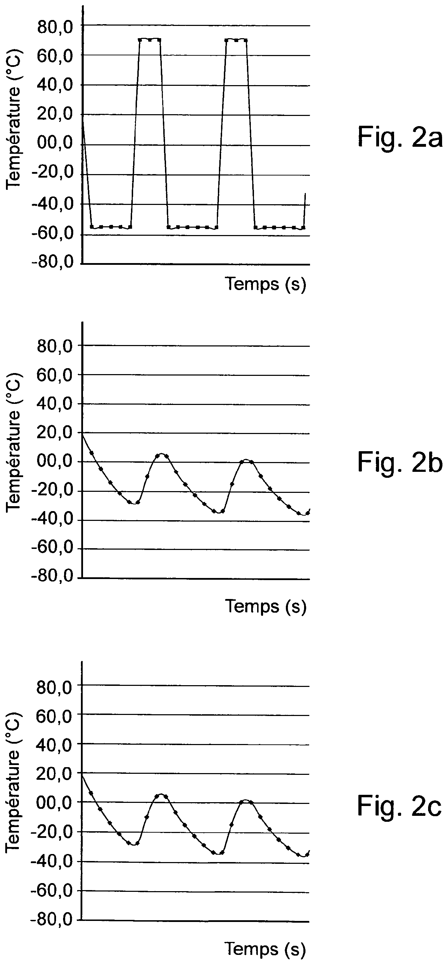

Comme l'on peut observer à la figure 2a, la température de l'air ambiant 5 entourant un aéronef peut varier de façon très importante, et par exemple elle peut varier entre -55° et 80°C. La figure 2a montre une variation de la température de l'air ambiant 5 extérieur à l'aéronef dans le temps. Les changements de température sont cycliques, correspondant par exemple à la fréquence de vol.

A la figure 2b, on peut observer que la température de la seconde source froide 6a amortie ces changements de température, celle-ci variant entre -35° et 20°C. Comme pour la figure 2a, la variation de la température est exprimée en fonction du temps.

Ainsi, grâce à la présence de la seconde source froide 6a de valeur de capacité thermique élevée, disposée entre la première source froide 5 et la carte électronique 1, la température de la carte électronique 1, varie également entre -35° et 20°C, comme l'on peut l'observer à la figure 2c. Comme pour les figures 2a et 2b, la variation de la température est exprimée en fonction du temps.

Ainsi, grâce à l'invention, il est possible d'augmenter la fiabilité et la durée de vie des équipements électroniques d'un aéronef et qui sont situés dans des zones non protégées de l'aéronef, les équipements étant ainsi exposés à des variations importantes de température.

Bien entendu, de nombreuses modifications peuvent être apportées aux exemples de réalisation décrits précédemment sans sortir du cadre de l'invention.

Par exemple, les matériaux employés comme seconde source froide peuvent être variés.

Par ailleurs, le boîtier peut comporter un nombre différent de capots, et peut présenter des formes variées.

**Revendications**

1. Système de dissipation de la chaleur produite par un système électronique (1), notamment par un équipement électronique (1) dans un aéronef, comportant un boîtier (4) qui comporte un capot externe (3) recouvrant ledit système électronique (1) et adapté à être en contact avec une première source froide (5), et une seconde source froide (6a) située à l'intérieur dudit capot externe (3), ledit boîtier (4) comportant un capot interne (8) situé à l'intérieur dudit capot externe (3) et recouvrant ledit système électronique (1), ladite seconde source froide (6a) étant située entre les capots interne (8) et externe (3).

2. Système de dissipation conforme à la revendication 1, **caractérisé en ce que** ledit capot interne (8) et ledit capot externe (3) forment une cavité (6) contenant la seconde source froide (6a).

3. Système de dissipation conforme à l'une des revendications 1 ou 2, **caractérisé en ce que** ladite seconde source froide (6a) a une valeur de capacité thermique supérieure à la valeur de capacité thermique de ladite première source froide (5).

4. Système de dissipation conforme à l'une des revendications 1 à 3, **caractérisé en ce que** le boîtier (4) comporte six faces, une première face (4a) étant fixée à un support (7) et les cinq autres faces étant adaptées à être en contact avec la première source froide (5).

5. Système de dissipation conforme à l'une des revendications 1 à 4, **caractérisé en ce que** ladite seconde source froide (6a) comporte de l'eau.

6. Aéronef, **caractérisé en ce qu'**il comporte un système de dissipation conforme à l'une des revendications 1 à 5.


**Patentansprüche**

1. System zur Abführung der durch ein elektronisches System (1), insbesondere durch eine elektronische Ausrüstung (1) in einem Luftfahrzeug, erzeugten Wärme, aufweisend ein Gehäuse (4), welches eine äußere Haube (3) aufweist, welche das elektronische System (1) abdeckt und dafür angepasst ist, mit einer ersten Kältequelle (5) in Kontakt zu sein, und eine zweite Kältequelle (6a), welche im Innenbereich der äußeren Haube (3) angeordnet ist, wobei das Gehäuse (4) eine innere Haube (8) aufweist, welche im Innenbereich der äußeren Haube (3) angeordnet ist und das elektronische System (1) abdeckt, wobei die zweite Kältequelle (6a) zwischen der inneren (8) und äußeren (3) Haube angeordnet ist.

2. Abführsystem nach Anspruch 1, **dadurch gekennzeichnet, dass** die innere Haube (8) und die äußere Haube (3) einen Hohlraum (6) bilden, welcher die zweite Kältequelle (6a) enthält.

3. Abführsystem nach einem der Ansprüche 1 oder 2, **dadurch gekennzeichnet, dass** die zweite Kältequelle (6a) einen Wärmekapazitätswert aufweist, welcher größer als der Wärmekapazitätswert der ersten Kältequelle (5) ist.

4. Abführsystem nach einem der Ansprüche 1 bis 3, **dadurch gekennzeichnet, dass** das Gehäuse (4) sechs Flächen aufweist, wobei eine erste Fläche (4a) an einem Träger (7) befestigt ist und die fünf weiteren Flächen dafür angepasst sind, mit der ersten Kältequelle (5) in Kontakt zu sein.

5. Abführsystem nach einem der Ansprüche 1 bis 4, **dadurch gekennzeichnet, dass** die zweite Kältequelle (6a) Wasser aufweist.

6. Luftfahrzeug, **dadurch gekennzeichnet, dass** es ein Abführsystem nach einem der Ansprüche 1 bis 5 aufweist.


**Claims**

1. System for dissipation of heat produced by an electronic system (1), in particular by an electronic equipment item (1) in an aircraft, comprising a housing (4) that includes an external lid (3) covering said electronic system (1) and configured to be in contact with a first cold source (5), and a second cold source (6a) located inside said external lid (3), said housing (4) including an internal lid (8) located inside said external lid (3) and covering said electronic system (1), said second cold source (6a) being located between the internal (8) and external (3) lids.

2. Dissipation system according to claim 1, **characterised in that** said internal lid (8) and said external lid (3) form a cavity (6) containing the second cold source (6a).

3. Dissipation system according to either of claims 1 and 2, **characterised in that** said second cold source has (6a) a heat capacity value greater than the heat capacity value of said first cold source (5).

4. Dissipation system according to one of claims 1 to 3, **characterised in that** the housing (4) comprises six faces, a first face (4a) being fastened to a support (7) and the other five faces being configured to be in contact with the first cold source (5).

5. Dissipation system according to one of claims 1 to 4, **characterised in that** said second cold source (6a) comprises water.

6. Aircraft, **characterised in that** it comprises a dissipation system according to one of claims 1 to 5.

EP 2 289 292 B1

Fig. 1

Fig. 2a

Fig. 2b

Fig. 2c

**EP 2 289 292 B1**

## RÉFÉRENCES CITÉES DANS LA DESCRIPTION

### Documents brevets cités dans la description

- EP 1615488 A
- EP 0144071 A
- FR 1266244